# EUROPEAN PATENT APPLICATION

(11) **EP 1 079 484 A2**
(43) Date of publication of application: **28.02.2001**
(21) Application number: 00117345.9
(22) Date of filing: 22.08.2000
(51) Int. Cl.: H01S 5/022, G02B 6/30

(54) **Semiconductor laser device, semiconductor laser module, and fiber module**

(30) Priority: 24.08.1999 JP 23761299
(71) Applicant: Mitsui Chemicals, Inc., Tokyo 100 (JP)
(72) Inventor: Okubo, Atsushi, c/o Mitsui Chemicals Inc., Sodegaura-shi, Chiba (JP); Yamada, Yoshikazu, c/o Mitsui Chemicals Inc., Sodegaura-shi, Chiba (JP)
(74) Representative: HOFFMANN - EITLE

(57) **Abstract**

A semiconductor laser device comprises a semiconductor laser chip comprising a semiconductor substrate and a compound semiconductor layer formed thereon, a base substrate formed of CuW, having a side on which the semiconductor laser chip is fixed in a junction-down fashion, and an intermediate section disposed on the side of the base substrate, comprising an electrically insulating portion and an electrically conductive portion insulated from the base substrate by the electrically insulating portion, the semiconductor substrate of the semiconductor laser chip and the electrically conductive portion being electrically interconnected. The semiconductor device of this construction is capable of outputting high power with high reliability over a long span.

## Description

### BACKGROUND OF THE INVENTION

### 1. Field of the Invention

The present invention relates to mounting of a high power semiconductor laser suited for communications, processing and instrumentation using light.

### 2. Description of the Related Art

Recently, a high power semiconductor laser is provided as fiber module constructed to couple the optical power outputted from the semiconductor laser to an optical fiber for the purpose of easy and safe handling of the optical power.

In such a fiber module are mounted such components as a Peltier device for temperature adjustment, a photodiode for monitoring the optical output and a thermistor for temperature measurement, as well as a semiconductor laser chip.

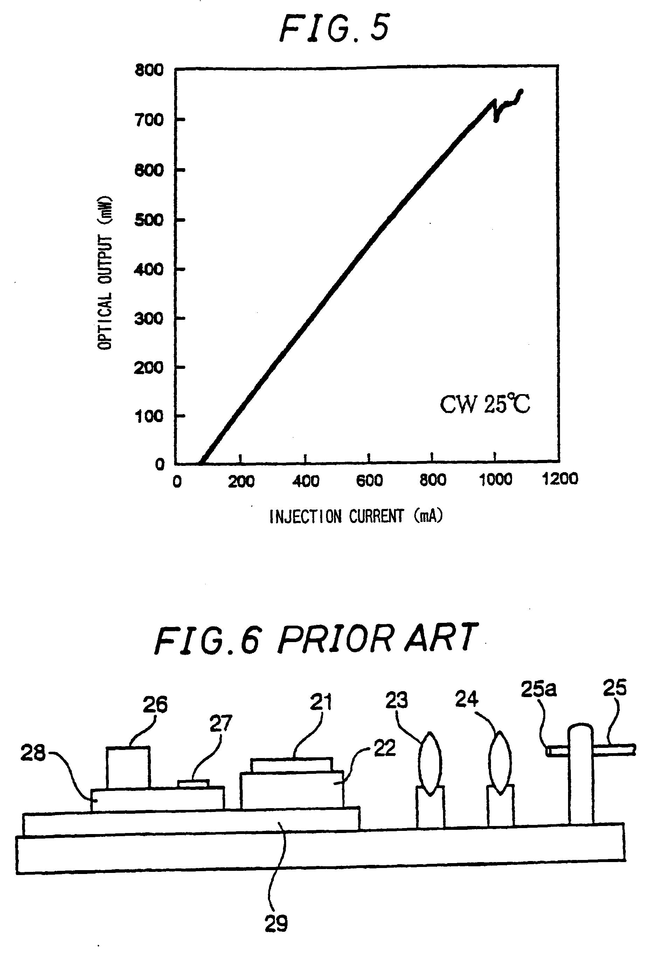

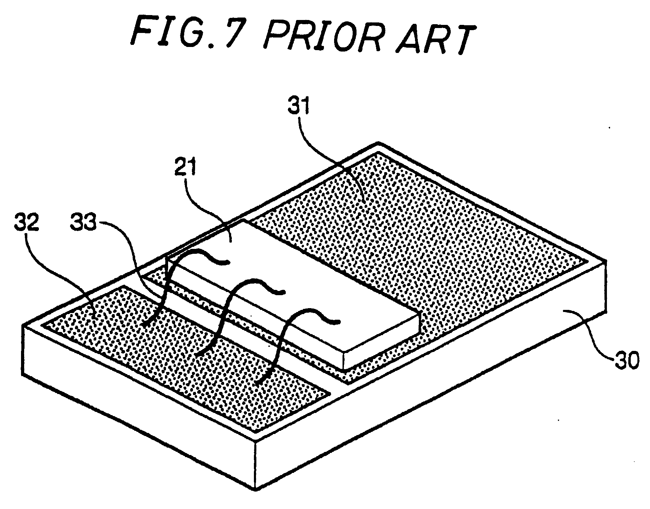

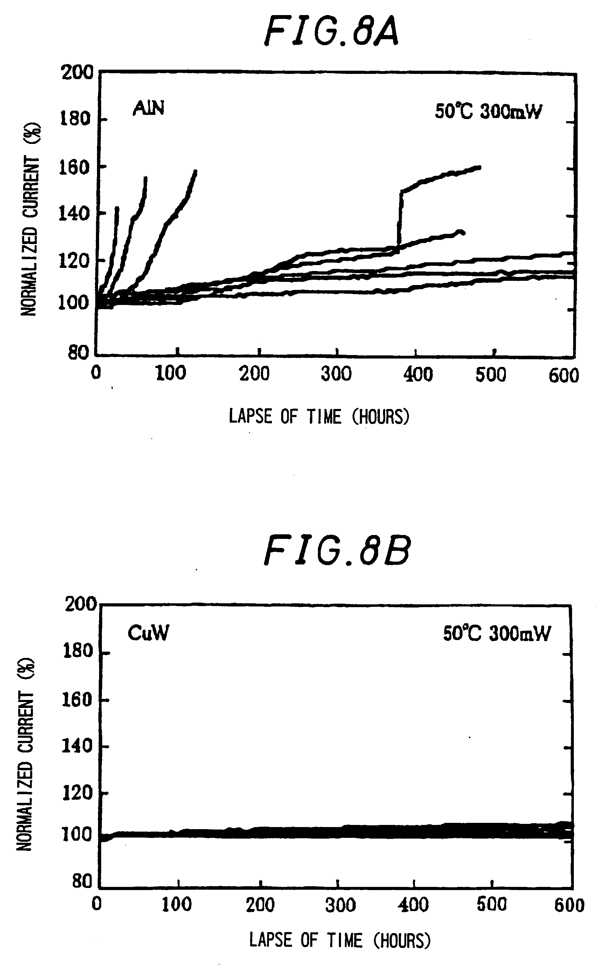

Methods of mounting such components adopt roughly divided two structure types. The first one, as shown in Fig. 6, is mainly applied to fiber modules of the type adapted to couple laser light outputted from a semiconductor laser chip 21 to an optical fiber 25 having a light-receiving terminal 25a through lenses 23 and 24, and is of the configuration in which a so-called open heat sink having the semiconductor laser chip 21 mounted on a heat sink 22 is mounted on a Peltier device 29 for temperature adjustment, and another substrate 28 mounted with a photodiode 26, a thermistor 27 and a like component is also mounted on the Peltier device 29.

However, in the case of high power semiconductor lasers of the GaAs/AlGaAs type having an InGaAs active layer for exciting erbium doped fiber amplifiers (EDFAs) which are being intensively developed particularly recently, the ellipticity of an emitted beam from such a laser is large and, hence, this type of lasers is unsuitable for lens coupling. For this reason, attempts are being made to couple laser light directly to an optical fiber having a light-receiving terminal processed.

Since a large space is used for this type of coupling within a fiber module, the second approach to more efficient mounting of a semiconductor laser has been attempted.

According to this approach, a semiconductor laser incorporated in a more compact COC (chip on carrier) configuration is mounted together with other components such as a photodiode and a thermistor on the same plane of a board having patterned wiring to realizes a higher density assembly.

This COC configuration will be more specifically described with reference to Fig. 7. A semiconductor laser chip 21 is fixed to an electrically insulating base substrate 30 by soldering that is a size larger than the semiconductor laser chip 21. On the base substrate 30 are formed islands 31 and 32 by patterning an electrically conductive layer. Interconnecting wires 33 extending from the other side, which is opposite to the fixed side, of the semiconductor laser chip 21 are connected to the island 32.

By taking this configuration, the semiconductor laser as in the COC configuration can readily be subjected to characteristic evaluation, screening test and the like and hence can be mounted in a fiber module by soldering after having been sufficiently evaluated.

To serve the purpose, the base substrate 30 of the COC configuration is formed of an insulator that allows patterning of an electrically conductive layer, typically a ceramic material such as aluminum oxide or aluminum nitride.

Such a mounting method is applicable to single transverse mode semiconductor lasers outputting a power of about 10 mW without any particular problem. However, the inventors of the invention have come to discover that the prior art mounting method cannot ensure long-span reliability for higher power semiconductor lasers.

### SUMMARY

It is an object of the invention to provide a semiconductor laser device, a semiconductor laser module and a fiber module which are capable of outputting high power with high reliability for a long span.

The present inventors have studied semiconductor laser mounting methods for enabling high power semiconductor lasers to generate stable oscillation over a long span, and as a result, reached the invention.

The invention provides a semiconductor laser device comprising a base substrate formed of a CuW thin plate, a semiconductor laser chip mounted on a side of the base substrate in a junction-down fashion, and an intermediate section having an electrically conductive portion insulated from the base substrate and formed on the same side of the base substrate, the semiconductor laser chip and the intermediate section being electrically interconnected. The semiconductor laser chip termed herein is one which comprises a compound semiconductor layer including an active layer, formed on a semiconductor substrate.

A high power semiconductor laser device needs to efficiently dissipate heat generated by laser oscillation from the semiconductor laser chip. To this end, the junction-down mounting method in which a semiconductor laser chip is fixed to a base substrate with its active layer-formed side facing opposite to the base substrate to position the heat-generating active layer closer to the base substrate for easier heat dissipation from the chip is preferred to the conventionally employed junction-up mounting method in which the semiconductor laser chip is fixed to the base substrate by soldering so that the substrate side, which is away from the active layer-formed side, faces opposite to the base substrate. However, it has been discovered that, since the thermal expansion coefficient of a ceramic material used for a conventional base substrate is different from that of the semiconductor laser material (GaAs or the like), a large residual stress resulting from soldering performed for fixing remarkably affects the long-span reliability of a higher power semiconductor laser. For this reason, the junction-down mounting of a semiconductor laser chip is unsuitable for applications attaching a particular importance to the reliability, and this fact is found to become a large obstacle against the higher power trend.

According to the invention, CuW (copper-tungsten) forming the base substrate has a thermal expansion coefficient that is very close to that of GaAs used as a material of a semiconductor laser and, hence, substantially no residual stress is given rise to by a temperature variation in soldering, whereby higher reliability can be ensured.

This effect becomes particularly noticeable when the length of a resonant cavity is made longer for higher power output. This is because a residual stress based on a difference in thermal expansion coefficient is proportional to the length of the coupling portion. More specifically, this effect becomes conspicuous as the resonant cavity length grows longer than 750 µm which is a typical length, particularly than 1.5 mm.

Further, the base substrate which, per se, is electrically conductive can secure higher conductivity than a conventional insulator substrate having patterned wiring, thereby making it possible to reduce a Joule loss which becomes a problem when the driving current is increased for providing a higher power. The semiconductor laser device of the invention can be subjected to a burn-in test prior to its mounting on a semiconductor laser module for sorting out primary defective products.

In the burn-in test a semiconductor laser device is fixed by the application of pressure with a probe or the like. In the case of a conventional semiconductor laser device comprising a ceramic substrate, a crack or fracture occurs in its substrate due to the application of pressure. To the contrary the metal substrate of the invention eliminates the occurrence of crack or fracture and makes it possible to apply high pressure for fixing and additionally achieve excellent thermal contact and electrical contact.

Figs. 8A and 8B are graphs showing an example of burn-in test results, Fig. 8A relates to a burn-in test of aluminium nitride(AlN) base substrate samples and Fig. 8B relates to a burn-in test of CuW base substrate samples. The samples are made in such a manner that semiconductor laser chips are fixed in a junction-down fashion on the AlN substrate and the CuW substrate, respectively, with AuSn solder. Changes in current with time are measured under test condition that the laser current is controlled so that a constant laser output of 500 mW is maintained in a 50°C atmosphere. The same initial current value is applied to the respective samples. Eight samples are tested in each of the graphs.

As shown in Fig. 8A, three of the eight samples are degraded due to increase in laser current within a lapse of 100 hours, two samples are degraded after a lapse of about 400 hours, and an increase in current is observed in the remaining three samples. To the contrary, all of the eight samples of Fig. 8B exhibit merely a slight increase in laser current and almost no degradation even after a lapse of 600 hours.

Such a semiconductor laser device is surface-mounted on a semiconductor laser module. Specifically, the base substrate bearing the semiconductor laser chip is fixed to a printed circuit board by soldering. On this printed circuit board may be mounted such components as a photodiode for monitoring the laser output and a thermistor for monitoring the temperature together with the semiconductor laser device to form a semiconductor laser module. Further, it is possible to form a fiber module by locating the input terminal of an optical fiber near the light-emitting edge of the semiconductor laser chip incorporated in such a semiconductor laser module. In the invention, the intermediate section may comprise a ceramic substrate, such as alumina (Al₂O₃) or aluminum nitride (AlN), having a metallized surface on a side for making electrical connection. In this case, use of such a ceramic substrate having a thickness substantially equal to that of the semiconductor laser chip provides no difference in height between two ends to be wire-bonded, thereby improving the yield and the electrical characteristics.

Another form of the intermediate section may comprise an insulating film formed on a portion of the base substrate by vapor deposition, coating of a paste or a like process, and a metal film formed on the insulating film by vapor deposition, coating of a paste or a like process. In this case, it is possible to form the intermediate section by batch processing thereby simplifying the manufacturing process. It is preferable that the content of Cu in the CuW used in the base substrate exists in a range of 1 wt.% to 20 wt.%. In the case of a semiconductor laser chip having a GaAs substrate, it is preferable that the content exists in a range of 10 wt.% and 20 wt.% since the thermal expansion coefficient of the base substrate approximates to that of the GaAs substrate.

To enhance the effect of the invention, it is preferable that the semiconductor laser chip used in the invention should be one which generates single transverse mode oscillation with a maximum output of 300 mW or more. The maximum power, at which the single transverse mode collapses and shifts to a transverse multimode, can be confirmed by the occurrence of a kink in the injection current vs. optical output (I-L) characteristic.

Such a semiconductor laser chip preferably has a carrier blocking layer between the active layer and each of the upper and lower waveguide layers. This carrier blocking layer is thin enough to allow light emitted at the active layer to leak to the adjacent waveguide layer, and has thickness and energy level such as to inhibit carriers injected to the active layer from the other side to overflow toward the adjacent waveguide layer. In this construction, the guided mode is sufficiently expanded to the waveguide layers, with the result that the peak value of the guided mode lowers, leading to a higher power.

Alternatively, in case of omitting such a carrier blocking layer, the semiconductor laser preferably has a structure such that the active layer is formed of a well having a small energy gap and thicker waveguide layers are formed. This structure also enables the peak value of the guided mode to lower thereby providing a higher power.

### BRIEF DESCRIPTION OF THE DRAWINGS

Other and further objects, features, and advantages of the invention will be more explicit from the following detailed description taken with reference to the drawings wherein.
Fig. 1 is a perspective view showing a semiconductor laser device as Embodiment 1 of the invention;
Fig. 2 is a perspective view showing a semiconductor laser device as Embodiment 2 of the invention;
Fig. 3 is a perspective view showing an example of a fiber module according to the invention;
Fig. 4 is a perspective view showing an example of a semiconductor laser module according to the invention;
Fig. 5 is a graph of an injection current vs. optical output characteristic of a semiconductor laser device used in an embodiment of the invention;
Fig. 6 is an illustration of a prior art semiconductor laser apparatus;
Fig. 7 is a perspective view showing a prior art semiconductor laser device; and
Figs. 8A and 8B are graphs showing an example of burn-in test results, Fig. 8A relates to a burn-in test of aluminium nitride(AlN) base substrate samples and Fig. 8B relates to a burn-in test of CuW base substrate samples.

### DETAILED DESCRIPTION OF THE PREFERRED EMBODIMENTS

Now referring to the drawings, preferred embodiments of the invention are described below.

### [Embodiment 1]

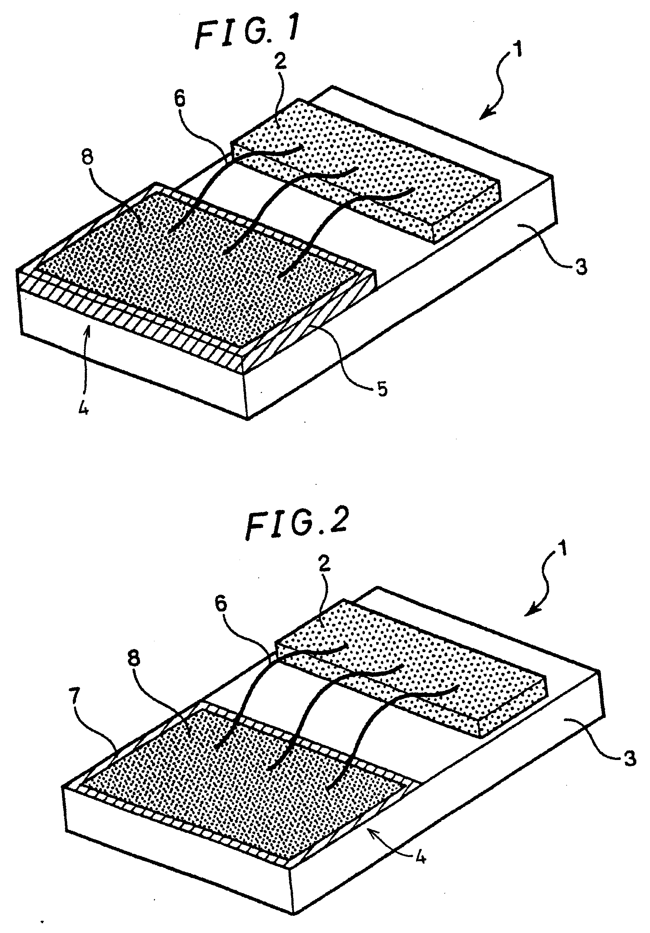

Fig. 1 illustrates a preferred embodiment of the invention. A semiconductor laser chip 2 includes compound semiconductor crystal layers such as an InGaAs active layer, formed on a GaAs substrate, and is designed to generate single transverse mode oscillation with a stripe width of 4 µm. The semiconductor laser chip 2 is mounted on abase substrate 3. The base substrate 3 is formed of Cu₁₀W₉₀, and is entirely plated with a Ni/Au double-layered coating film (not shown). On the same side of the base substrate 3 is fixed by the use of an AuSn solder a plate-shaped intermediate section 4 comprising an AlN substrate plated with an electrically conductive film 8 of Au on a top side thereof. The semiconductor laser chip 2 is fixed on the Ni/Au coat of the base substrate 3 using an AuSn solder in a junction-down mounting fashion in which the side, toward which the compound semiconductor layers are grown from the GaAs substrate, of the semiconductor chip is fixed on the base substrate. Thus, a direct electrical contact is made between the compound semiconductor layers and the base substrate. The surface of the GaAs substrate of the semiconductor chip 2 is wire-bonded to the electrically conductive Au film 8 of the intermediate section via wires 6 for supplying electric energy.

As compared with a conventional base substrate having an electric resistance of about 1 ohm, the base substrate used in the invention has an electric resistance reduced to about 0.1 ohm, thereby enabling higher power oscillation. The semiconductor laser device mounted on the base substrate outputs light of 0.98 µm wavelength with an injection current vs. optical output characteristic shown in Fig. 5 and generates single transverse mode oscillation until the optical output reaches 700 mW. When this semiconductor laser device was operated at a high temperature for a long span, no change was observed in its characteristics. Further, by making the intermediate section 4 have a thickness substantially equal to the thickness of the semiconductor laser chip 2 in this embodiment, the respective heights of the portions to be wire-bonded become substantially equal to each other thereby facilitating the wire bonding with higher reliability.

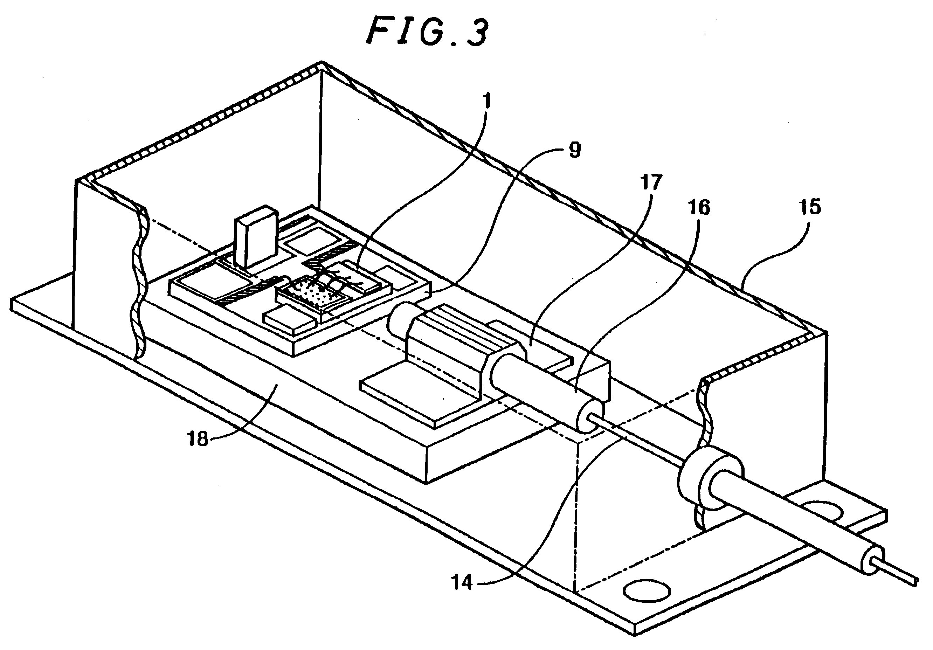

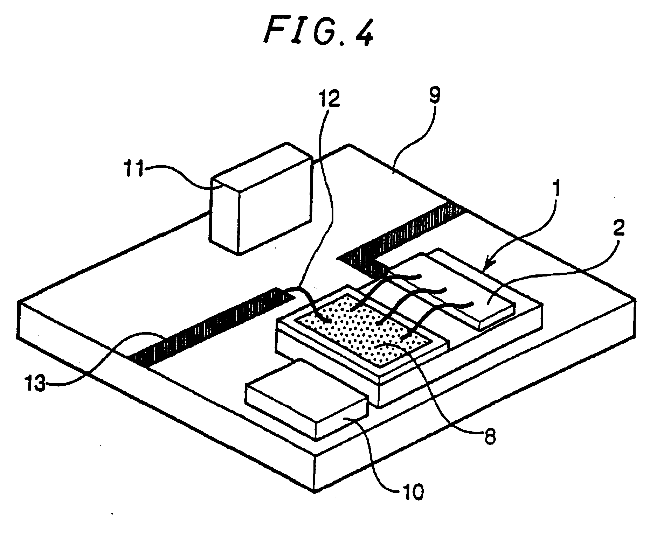

Fig. 4 illustrates this semiconductor laser device as mounted on a printed circuit board. Semiconductor laser device 1 bearing the semiconductor laser chip 2 is fixed to a predetermined location on the printed circuit board by soldering. The electrically conductive film 8 and a patterned electrically conductive layer 13 of the printed circuit board are electrically interconnected through a wire 12. On the printed circuit board may be mounted a photodiode 11 for monitoring the output of the semiconductor laser chip 2 and a thermistor 10 together with the semiconductor laser device 1. Fig. 3 illustrates a fiber module incorporating the semiconductor laser device as mounted thereon. In this fiber module, an optical fiber 14 partially accommodated in a protective tube 16 has an input terminal fixed by a support 17 at a location close to the light-emitting edge of the semiconductor laser chip. The input terminal of the optical fiber 14 is shaped like a wedge. The printed circuit board 9 and the support 17 are fixed on a base pad 18 provided with a Peltier device, and the entirety is housed in a case 15 to form the fiber module.

### [Embodiment 2]

Fig. 2 illustrates another preferred embodiment of the invention. Semiconductor laser chip 2 is mounted on base substrate 3 in a junction-down fashion, as in Embodiment 1. A portion of the upper side of the base substrate 3 is formed with an intermediate section comprising an insulating film 7 of SiO₂ and an electrically conductive film 8 of Au insulated from the base substrate 3, which are stacked in this order. The substrate surface of the semiconductor laser chip 2 is wire-bonded to the Au conductive film 8 of the intermediate section 4 through wires 6 for supplying electric energy. The semiconductor device of such a COC configuration is reliable for a long span like Embodiment 1 and allows the intermediate section to be formed by batch processing, for example, vapor deposition or paste coating to the base substrate.

It should be noted that the embodiments described herein are not limitative of the invention; for example, the substrate of the semiconductor laser chip may be formed of InP or a like material.

Further, the CuW material used for the base substrate may be either a homogeneous one or a gradient one of which composition is varied continuously or stepwise. For example, a CuW material having a Cu richer portion than the rest may be used for the base substrate so that only a portion of the base substrate to be mounted with the semiconductor laser comprises the Cu richer portion. In this case, both thermal conductivity and electrical conductivity respectively approximating to those of Cu and a thermal expansion coefficient approximating to that of CuW can be enjoyed.

The invention may be embodied in other specific forms without departing from the spirit or essential characteristics thereof. The present embodiments are therefore to be considered in all respects as illustrative and not restrictive, the scope of the invention being indicated by the appended claims rather than by the foregoing description and all changes which come within the meaning and the range of equivalency of the claims are therefore intended to be embraced therein.

## Claims

1. A semiconductor laser device comprising:
a semiconductor laser chip (2) comprising a semiconductor substrate and a compound semiconductor layer formed thereon;
a base substrate (3) formed of CuW, on which the semiconductor laser chip (2) is fixed in a junction-down fashion;
an intermediate section (4) formed on a chip-fixing side of the base substrate (3), comprising an electrically insulating portion (5) and an electrically conductive portion (8) insulated from the base substrate (3) by the electrically insulating portion (5, 7); and
a connecting section (6) electrically interconnecting the semiconductor substrate and the electrically conductive portion (8).

2. The semiconductor laser device of claim 1, wherein the electrically insulating portion of the intermediate section (4) is formed of a ceramic substrate (5), and the electrically conductive portion (8) of the intermediate section (4) is formed of an electrically conductive layer on the ceramic substrate.

3. The semiconductor laser device of claim 1, wherein the intermediate section comprises an electrically insulating film formed on a portion of the chip-fixing side of the base substrate, and an electrically conductive film formed on the electrically insulating film.

4. The semiconductor laser device of any one of claims 1 to 3, wherein the semiconductor laser chip (2) is capable of outputting a maximum power of 300 mW or more in single transverse mode oscillation.

5. The semiconductor laser device of any one of claims 1 to 3, wherein the semiconductor laser chip (2) has a resonant cavity length of 1.5 mm or more.

6. The semiconductor laser device of any one of claims 1 to 3, wherein the semiconductor substrate is formed of GaAs.

7. A semiconductor laser module comprising:
a printed circuit board (9) having a patterned electrically conductive layer (13); and
the semiconductor laser device (1) of any one of claims 1 to 6, being mounted on the printed circuit board (9).

8. A fiber module comprising:
the semiconductor laser module of claim 7; and
an optical fiber (4) having an input terminal fixed at a location close to an output terminal of the semiconductor laser chip (2).
